# EUROPÄISCHE PATENTSCHRIFT

(11) **EP 0 866 372 B1**
(45) Veröffentlichungstag und Bekanntmachung des Hinweises auf die Patenterteilung: **06.09.2000**
(21) Anmeldenummer: 98101418.6
(22) Anmeldetag: 28.01.1998
(51) Int. Cl.: G03F 1/16

(54) **Membranmaske für Belichtungsverfahren mit kurzwelliger Strahlung**
Membrane mask for short wavelength radiaton exposure process
Masque à membrane pour procédé d'exposition au rayonnement à courte longueur d'onde

(30) Priorität: 17.03.1997 DE 19710799
(43) Veröffentlichungstag der Anmeldung: 23.09.1998
(73) Patentinhaber: International Business Machines Corporation, Armonk, N.Y. 10504 (US)
(72) Erfinder: Greschner, Johann, Dr., 72124 Pliezhausen (DE); Kalt, Samuel, 72760 Reutlingen (DE); Meissner, Klaus, 71083 Herrenberg-Kayh (DE); Paul, Rudolf, 75397 Simmozheim (DE)
(74) Vertreter: Teufel, Fritz, Dipl.-Phys.

(56) Entgegenhaltungen:
- EP-A- 0 729 175
- RANDALL,J.N.; FLANDERS,D.C.; ECONOMOU,N.P.; DONNELLY,J.P.; BROMLEY,E.I.: "High Resolution ion beam lithography at large gaps using stencil masks" APPL. PHYS. LETT., Bd. 42, Nr. 5, 1983, XP002069836
- PATENT ABSTRACTS OF JAPAN vol. 097, no. 012, 25.Dezember 1997 & JP 09 223658 A (NIKON CORP), 26.August 1997,
- OLSCHIMKE J ET AL: "PERIODIC SI-HOLE-MASKS IN THE M AND SUB- M RANGE FOR ELECTRON- MULTIBEAMWRITING" MICROELECTRONIC ENGINEERING, Bd. 5, Nr. 1 - 4 + INDEX, Dezember 1986, Seiten 405-412, XP000039750

## Beschreibung

Die Erfindung betrifft Membranmasken für Belichtungsverfahren mit kurzwelliger Strahlung.

Belichtungsverfahren mit kurzwelliger Strahlung, zu denen Röntgen-, Elektronen- und Ionenstrahlverfahren zählen, verdrängen mit zunehmender Verkleinerung der abzubildenden Strukturen die optische Lithographie immer mehr. Sie werden zur Herstellung von Belichtungsmasken oder zur Direktbelichtung von Halbleiterwafern eingesetzt und bei angestrebten Strukturbreiten von nur ungefähr 0.2 µm bei der 1 GBit Chipgeneration werden sie die dominanten Lithographieverfahren sein.

Während die Maskensubstrate für die herkömmliche optische Lithographie aus relativ dicken (einige mm) Quarzplatten bestehen, die für die üblichen Lichtwellenlängen transparent sind, wird bereits seit Anfang der siebziger Jahre versucht, für die Röntgen-, Elektronen- und Ionenstrahlverfahren Membranmasken einzusetzen. Dies erlaubt bei höherer Auflösung einen ausreichenden Durchsatz von Halbleiterwafern.
Die Wechselwirkungen der drei genannten kurzwelligen Strahlungen mit der Maske erfordern Membranmasken mit einer Dicke von ungefähr 0.1 µm bis zu einigen µm.

Die Masken für das Ionenstrahlverfahren benötigen als Muster Löcher in der Membran, während für die Röntgen- und Elektronenstrahlbelichtung zusätzlich auch geschlossene Membranen mit Metallabsorbermuster benutzt werden können.

In all diesen Fällen wird die Membranmaske hergestellt, indem ein Elektronenstrahlmustergenerator die entsprechenden Muster in Fotolack schreibt. Für Strukturen kleiner als 0.5 µm wird die Eckenqualität von den geschriebenen Mustern schlecht, die Ecken verrunden.

Durch Ätzprozesse wird das Muster anschließend in die Membran bzw. in die Absorberschicht übertragen. Die meist eingesetzten anisotropen Plasmaätzverfahren zeichnen sich durch formgetreue Musterübertragung aus, d.h. die im Fotolack bereits verrundeten Ecken werden als verrundete Ecken nahezu gleicher Dimension in die Membran übertragen.

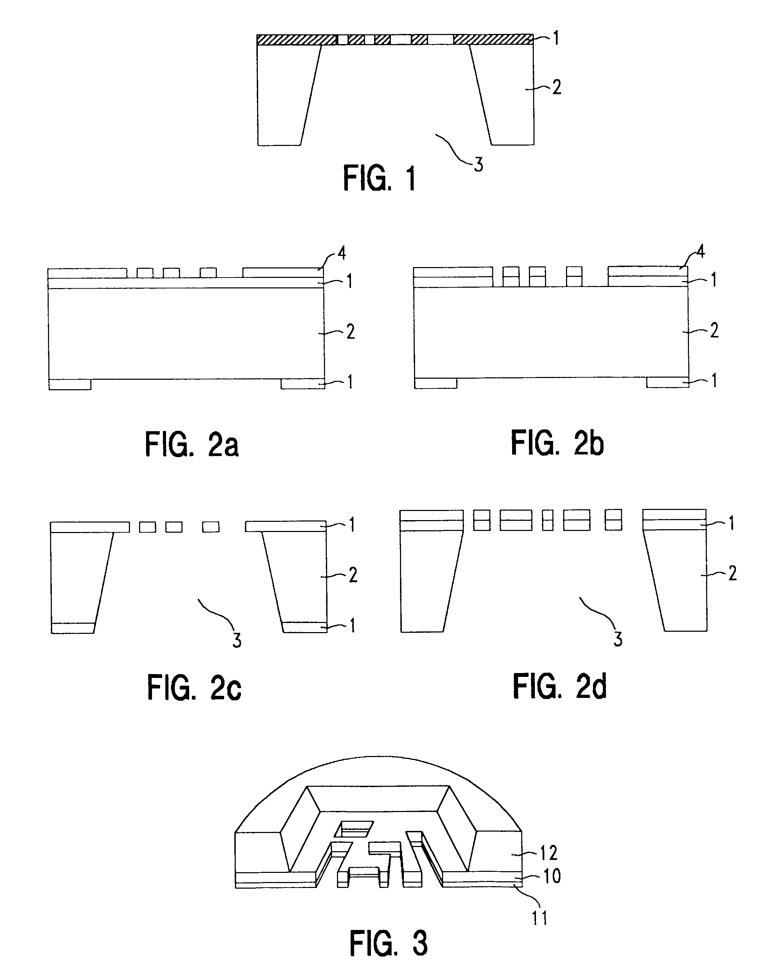

Schattenwurfmasken oder Lochmasken, wie in Fig. 3 dargestellt, bei denen das Muster aus physikalischen Löchern besteht und die z.B. in den europäischen Patenten EP 0 019 779 oder EP 0 078 336 beschrieben sind, sind bisher ausschließlich mit einer Membran 10 aus Silizium realisiert worden.

Bei der Schattenwurfmaske in EP 0 019 779 weist das n-dotierte Siliziumsubstrat eine p-dotierte Oberflächenschicht, die Membran, auf, die mit einer dünnen Chromschicht sowie zwei darüber aufgebrachten Goldschichten belegt ist. Diese insgesamt einige hundert nm (maximal ungefähr 1 µm) dicke Goldschicht diente dazu, die Elektronen in den undurchlässigen Maskenbereichen völlig abzubremsen.

Die Membrandicken liegen im Bereich von etwa 1 bis 4 µm, typischerweise bei 2µm. Solche Siliziummembranen können über den Dotierungsätzstop uniform hergestellt werden. Mit geringer werdenden Strukturgrößen und abnehmender Membrandicke werden die Anforderungen an das anisotrope Plasmaätzen immer höher und als Dotierungsätzstop wird eine extrem hohe p-Dotierung erforderlich, z.B. eine Bordotierung von ungefähr 1.3 x 10²⁰ Boratome/cm³. Siliziummembranen mit dieser Ätzstopdotierung zeigen eine hohe Zahl von Versetzungsfehlstellen und sind mechanisch äußerst fragil.

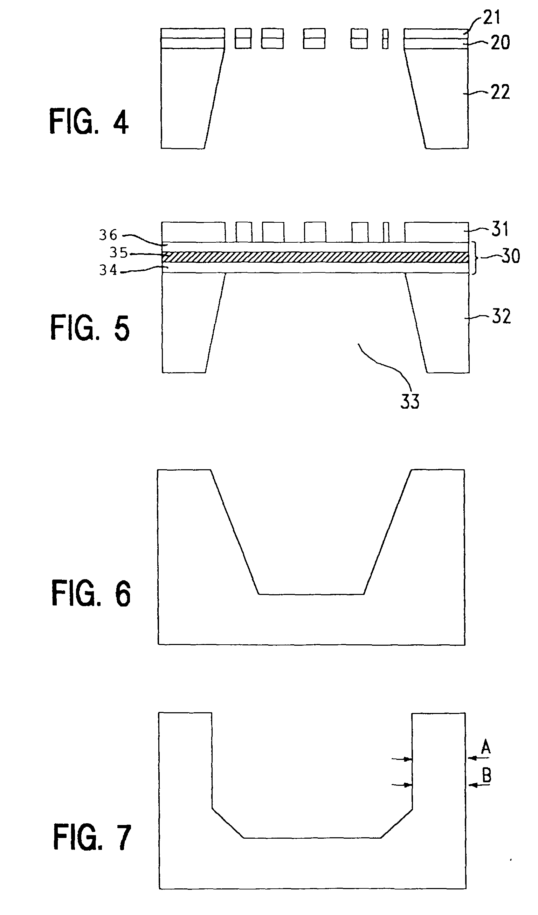

Bei Masken mit einer geschlossenen Membran für die Röntgenstrahl-lithographie, wie in Fig. 4 dargestellt, ist das Muster in Form eines strukturierten metallischen Absorbermaterials 21 auf der Membran 20 ausgebildet.
Damit die Membran für Röntgenstrahlen transparent ist, darf sie nur wenige µm dick sein und das Membranmaterial sollte eine möglichst geringe Kernladungszahl besitzen, um an den transparenten Stellen möglichst wenig Strahlung zu absorbieren.

Das Absorbermaterial ist ebenfalls nur wenige µm dick und besitzt eine möglichst hohe Kernladungszahl. Typische Metallabsorber bestehen aus Wolfram oder Gold und für die Membran wurden Materialien wie Silizium, Siliziumnitrid, Siliziumkarbid, ein Silizid wie in EP 0 048 291 vorgeschlagen oder neuerdings auch Diamant gewählt.

Träger für die Membran ist ein Siliziumwafer 22, der durch anisotropes Ätzen mindestens eine durchgehende Öffnung aufweist, deren Seitenwände aus (111)-Ebenen bestehen und 54,7° gegen die (100)-Oberfläche des Siliziumwafers geneigt sind.

Bei diesen Masken ist bis heute das Problem der Maskenverzeichnungen bedingt durch ungleichmäßigen mechanischen Stress in der Membran nicht zufriedenstellend gelöst. Mechanische Verzerrungen können sowohl durch das Membranmaterial selbst als auch durch das Absorbermaterial verursacht sein. Zudem besteht die Schwierigkeit, das metallische Absorbermaterial mittels reaktivem Ionenätzen im Submikronbereich zu strukturieren.

Vor wenigen Jahren wurde von S.D.Berger et al. in J.Vac.Sci.Technol. B9(6), Nov/Dec 1991, p.2996-2999, "Projection electron-beam lithography: A new approach" ein Elektronenstrahlprojektionsverfahren vorgeschlagen, das Elektronen hoher Energie verwendet und eine neue Membranmaskentechnik erforderte. Die auch von Huggins et al. in Proceedings of SPIE 1995, Vol. 2621, p. 247-255 und von J.A.Liddle et al. in Proceedings of SPIE 1994, Vol. 2322, p. 442-451 beschriebene SCALPEL™ Maske (Scanning with Angular Limitation Projection Electron-Beam Lithography) ähnelt den für die Röntgenstrahllithographie eingesetzten geschlossenen Membranmasken.

Die Schichtdicken der Membran und der Metallabsorberschicht sind bei den SCALPEL Masken geringer. Elektronen von ungefähr 100 keV durchdringen beide Schichten, werden aber an den Schichten unterschiedlich stark gestreut, was zu einer verkleinernden Abbildung ausgenutzt wird.

Im Gegensatz zu den für die Röntgenstrahllithographie verwendeten Membranmasken ist die SCALPEL Maske in kleinere Maskenfelder unterteilt. Diese Unterteilung erlaubt Stützwände, die eine bessere mechanische und thermische Stabilität garantieren.
Um den Flächenverlust zwischen den Maskenfeldern möglichst gering zu halten, sind die dünnen Stützwände senkrecht zur Waferoberfläche angeordnet und durch anisotropes Naßätzen aus einem (110)-Wafer hergestellt worden.

Ähnlich wie bei den Röntgenstrahllithographiemasken treten bei den SCALPEL Masken Spannungsprobleme durch die Membran und/oder die Metallabsorberschicht auf. Bei den u.a. in Proceedings of SPIE 1995, Vol. 2621, p. 247-255 beschriebenen Masken sind die Maskenfelder lange schmale Streifen, sodaß die freitragenden Membranteile aus Rechtecken von ungefähr 1 mm x 2 cm Größe bestehen. Da die Membranen unter Zugspannung stehen müssen, treten in x- und y-Richtung unterschiedliche Zugspannungen auf, was zu einer anisotropen Verzerrung des Maskenmusters führt.

US 5,260,151 zeigt SCALPEL Masken mit quadratischen Maskenfeldern von ungefähr 1 mm Kantenlänge, bei denen die die Maskenfelder gegeneinander abgrenzenden, 0.1 mm dicken und 1.0 mm hohen Stützwände senkrecht zur Membran aus polykristallinem Silizium angeordnet sind. Damit wird eine isotrope Streßverteilung in der Membran erreicht. Die Herstellung der dünnen, senkrechten Stützwände mit anisotropen Plasmaätztechniken, ohne die Membran zu beschädigen, ist allerdings problematisch.

Es ist die Aufgabe der Erfindung, Membranmasken für Elektronenstrahlbelichtungsverfahren bereitzustellen, die eine hohe mechanische Stabilität und Spannungsfreiheit bei geringer Membrandicke aufweisen und mit reaktiven Ionenätzverfahren leicht herzustellen sind.

Diese Aufgabe wird erfindungsgemäß gelöst durch die Membranmaske nach Anspruch 1.

Die Verwendung von Siliziumnitrid als Membranmaterial anstelle von mit Bor hochdotiertem Silizium bietet den Vorteil, die Membran mit geringerer Dicke ausbilden zu können und dennoch eine mechanisch robustere Membran zu erhalten. Die verringerte Membrandicke erleichtert das Plasmaätzen erheblich und die wesentlich höhere Ätzselektivität des Nitrids zu dem tragenden Halbleiterplättchen aus Silizium macht den Gesamtherstellungsprozeß der Maske insgesamt kostengünstiger als dies bei der Verwendung von Siliziummembranen möglich ist.
Die Ausbildung der durchgehenden Membranschicht als Schichtkombination aus Siliziumdioxid / Siliziumnitrid / Siliziumdioxid bietet ebenfalls bei geringster Schicktdicke genügend mechanische Stabilität.

Das Herstellverfahren ermöglicht es, lithographisch erzeugte Muster ohne die sonst übliche Kantenverrundung in die das Maskenmuster definierende Schicht, die Membran, zu übertragen.

Die Erfindung wird anhand von durch Zeichnungen erläuterten Ausführungsbeispielen näher beschrieben.
- Fig. 1: zeigt den schematischen Querschnitt durch eine Membranmaske
- Fig. 2a bis 2d: zeigen die zur Herstellung der in Fig.1 dargestellten Maske notwendigen Prozeßschritte
- Fig. 3: ist die Darstellung einer aus dem Stand der Technik bekannten Lochmaske
- Fig. 4: ist die Darstellung einer aus dem Stand der Technik bekannten Maske mit einer geschlossenen Membran für die Röntgenstrahllithographie
- Fig. 5: zeigt den schematischen Querschnitt durch eine bevorzugte Ausführungsform der Erfindung
- Fig. 6: zeigt das Ergebnis von den aus dem Stand der Technik bekannten anisotropen Naßätzverfahren
- Fig. 7: zeigt das Ergebnis des Plasmaätzverfahrens
- Fig. 8a: zeigt den Querschnitt durch die Struktur von Fig.7 in der Höhe A
- Fig. 8b: zeigt den Querschnitt durch die Struktur von Fig.7 in der Höhe B

Der in Fig.1 gezeigte schematische Querschnitt zeigt eine Membranmaske. Bei dieser Membranmaske zur Strukturierung von Oberflächenbereichen mit Hilfe von Elektronen- oder Korpuskularstrahlen ist auf einer Oberfläche eines Halbleiterplättchens 2, das vorzugsweise aus Silizium besteht, eine Schicht 1 aus Siliziumnitrid aufgebracht. Die Siliziumnitridschicht hat durchgehende Öffnungen, die das Maskenmuster definieren. Von der anderen Oberfläche des Halbleiterplättchens 2 erstreckt sich eine wannenförmige Vertiefung 3 bis hin zur schichttragenden Oberfläche.

Die Siliziumnitridschicht ist ungefähr 0.1 µm bis 2.0 µm dick und steht günstigerweise unter einer Zugspannung von ungefähr 10⁸ dynes/cm². Eine solche Siliziumnitridmembran ist mechanisch stabil und kann laut S.D.Berger et al. in J.Vac.Sci.Technol. B9(6), Nov/Dec 1991, p.2996-2999, "Projection electron-beam lithography: A new approach" bei einer Dicke von nur 0.1 µm über eine Fläche von einigen mm² eine Druckdifferenz von einer Atmosphäre aushalten.

Fig. 2a bis 2d zeigen die zur Herstellung der Maske aus Fig.1 erforderlichen Prozeßschritte. In Fig.2a ist auf der Frontseite eines beidseitig polierten Halbleiterwafers 2 die spätere Membran 1 als LPCVD (low pressure chemical vapor deposition) Siliziumnitrid Si₃N₄ aufgebracht. Zu beachten sind die laterale Spannungskontrolle in der Nitridschicht und ein Spannungsgradient senkrecht zur Schichtoberfläche sollte ebenfalls vermieden werden.
Die gleichzeitig auf der Rückseite des Halbleiterwafers 2 aufgebrachte Nitridschicht 1 kann als Maske für den späteren Waferdünnungsschritt genutzt werden. Auf die frontseitige Nitridschicht 1 wird eine Photolackschicht 4 aufgebracht, mit dem Maskenmuster belichtet und entwickelt.

Mittels eines anisotropen Plasmaätzschritts wird das Maskenmuster in die frontseitige Nitridschicht 1 übertragen, wie in Fig.2b dargestellt. Als Ätzmedium wird ein SF₆/O₂-Gasgemisch eingesetzt, dessen Mischungsverhältnis in Abhängigkeit von der Geometrie der Plasmaätzanlage so gewählt wird, daß das Plasmaätzen im wesentlichen Fenster mit senkrechten Wänden in der Siliziumnitridschicht 1 herstellt. Das Plasma wird mittels einer Heliconwendel erzeugt. Die für diesen Ätzprozeß günstigen Temperaturen liegen im Bereich von ungefähr -90° C bis ungefähr -140° C, typischerweise bei -130° C.

Diese Ätzbedingungen ermöglichen bei einer Siliziumschicht ein partiell kristallorientierungsabhängiges Ätzen, bei dem das zu ätzende Muster zu Beginn des Ätzprozesses noch in der Form geätzt wird, wie sie von der maskierenden Photolackschicht vorgegeben wird, z.B. als kreisförmige Scheibe. Während des Tiefenätzens geht der kreisförmige Querschnitt in einen quadratischen Querschnitt über. Die Seitenwände des geätzten Musters werden wesentlich durch die Kristallorientierung beeinflußt, sind aber nicht wie beim anisotropen Naßätzen echte Kristallebenen.

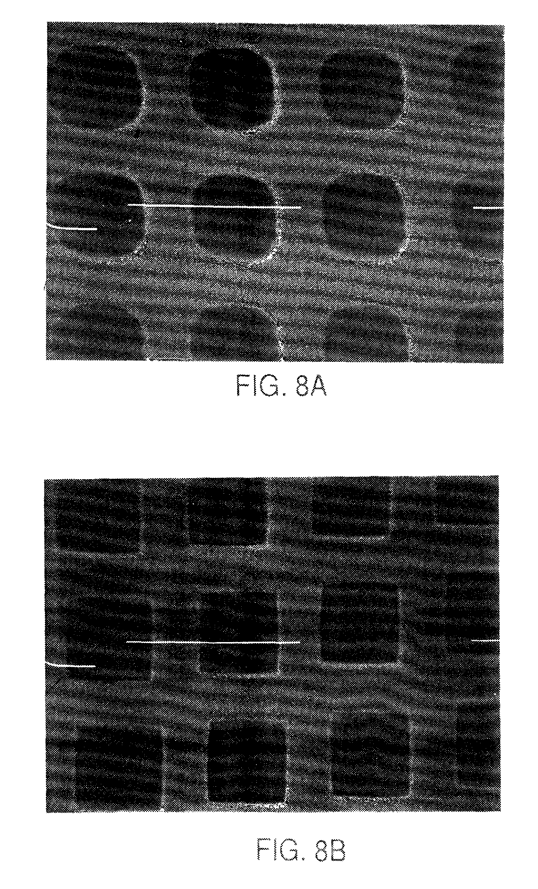

Wird ein zu ätzender Siliziumwafer in (110)-Richtung orientiert, dann werden mit den bekannten anisotropen Naßätzverfahren, z.B. mit verdünnter KOH, die Seitenwände unter 54.7° geätzt und es ensteht, wie in Fig.6 schematisch dargestellt, eine V-förmige Grabenstruktur.

Wird ein in (110)-Richtung orientierter Wafer partiell kristallorientierungsabhängig geätzt, dann bildet sich die in Fig. 7 schematisch dargestellte Grabenstruktur aus. Wurde von der Photolackschicht ein kreisförmiges Muster vorgegeben, so hat im Bereich der Querschnittsebene in der Höhe A die geätzte Struktur ebenfalls noch einen kreisförmigen Querschnitt. Im Bereich der Querschnittsebene in der Höhe B hingegen hat die geätzte Struktur einen quadratischen Querschnitt mit senkrechten Seitenwänden.

Die elektronenmikroskopische Aufnahme einer auf diese Weise erzeugten Maskenstruktur ist in Fig. 8a und 8b zu sehen. Fig.8a zeigt den Querschnitt durch die in Fig.7 dargestellte Struktur in der Höhe A mit deutlich verrundeten Ecken. In Fig.8b ist der Querschnitt durch die in Fig.7 dargestellte Struktur in der Höhe B zu sehen, nachdem die Schicht bis zur Höhe B abgetragen wurde. Dieses elektronenmikroskopische Bild zeigt die Verbesserung der Qualität des lithographisch erzeugten Musters, die mit dem Plasmaätzverfahren zu erzielen ist.

Mit diesem partiell kristallorientierungsabhängigen Ätzen ist es möglich, trotz bereits verrundeter Ecken im strukturierten Photolack exakte Eckstrukturen mit senkrechten Seitenwänden zu erzeugen. Damit läßt sich die Musterqualität von Membranmasken erheblich verbessern.

Nach dem Plasmaätzschritt, in Fig.2b dargestellt, wird die Photolackschicht entfernt und der Halbleiterwafer wird in einer KOH-Lösung durch das rückseitige Si₃N₄-Fenster zur Ausbildung einer wannenförmigen Vertiefung 3 weggeätzt, Fig. 2c. Die Ätzselektivität von Nitrid zu Silizium ist > 1:1000 und so benötigt die bereits strukturierte Siliziumnitridschicht 1 keinen besonderen Schutz während des Naßätzens.

Die nun fertiggestellte Membranmaske kann, wie in Fig.2d dargestellt, noch eine oder mehrere Metallschichten 5, aufgebracht auf die Siliziumnitridschicht 1, enthalten, je nach geplanter Verwendung der Maske. Hierfür eignen sich insbesondere Metalle wie Gold, Platin oder Wolfram.

In Fig. 5 ist im schematischen Querschnitt die bevorzugte Ausführungsform der Erfindung dargestellt. Die Maske zur Strukturierung von Oberflächenbereichen mit Hilfe von Elektronenstrahlen hat mindestens eine durchgehende Schicht 30 und eine das Maskenmuster definierende Schicht 31.
Diese beiden Schichten sind auf der Oberfläche eines Halbleiterplättchens 32 aufgebracht, das eine wannenförmige Vertiefung 33 aufweist, die sich von der anderen Plattenoberfläche in das Halbleitermaterial 32 bis hin zur schichttragenden Oberfläche hineinerstreckt.

Die durchgehende Schicht 30 ist als Schichtkombination aus einer Siliziumdioxidschicht 34, einer Siliziumnitridschicht 35 und einer Siliziumdioxidschicht 36 ausgebildet. Die Schichtdicken der die Schichtkombination bildenden Schichten 34, 35, 36 sind so aufeinander abgestimmt sind, daß die Schichtkombination insgesamt unter einer geringen Zugspannung steht, die bei 10⁸ dynes/cm² liegt. Die beiden Siliziumdioxidschichten 34, 36 haben im allgemeinen kompressive Spannung, während die als LPCVD-Nitrid aufgebrachte Schicht 35 unter Zugspannung steht.

Außer dem wesentlichen Vorteil, mittels geeigneter Dickenwahl die Spannung in der Schichtkombination zu kontrollieren, hat diese Schichtfolge auch entscheidende Vorteile während des Maskenherstellprozesses.
Siliziumdioxid stellt sowohl für das anisotrope Naßätzen von der Rückseite als auch für das anisotrope Plasmaätzen von der Frontseite jeweils einen hervorragenden Ätzstop dar.

Die Dicke der Schichtkombination 30 sollte bei ausreichender mechanischer Stabilität möglichst gering sein, um eine möglichst geringe Elektronenstreuung und vernachlässigbare Absorption zu gewährleisten. Die bevorzugte Dicke liegt im Bereich von 0.1 µm bis 0.4 µm.

Die das Maskenmuster definierende Schicht 31 sollte eine höhere Dicke haben, die vorzugsweise bei 2.0 µm liegt.

Als Schichtmaterial ist einkristallines oder polykristallines Silizium besonders geeignet. Durch geeignete Dotierung des Siliziums kann die Spannung innerhalb der Schicht 31 eingestellt werden.

Zur Herstellung der Maske bringt man auf einem Halbleiterwafer, vorzugsweise aus Silizium, nacheinander die Schichten Siliziumoxid-Siliziumnitrid-Siliziumoxid-Polysilizium auf. Danach werden Frontseite und Rückseite des Wafers mit Siliziumdioxid und Photolack maskiert. Durch das Rückseitenfenster wird mittels KOH die wannenförmige Vertiefung ausgebildet und das eigentliche Muster wird frontseitig durch den anisotropen Plasmaätzschritt erzeugt.

Anstelle von polykristallinem Silizium kann auch monokristallines Silizium als Schicht 31 verwendet werden. In diesem Fall ist der Herstellungsprozeß etwas aufwendiger, kann aber durch die bessere Spannungskontrolle bei monokristallinem Silizium sinnvoll sein. Ausgangsmaterialien sind in diesem Fall zwei verschieden beschichtete Halbleiterwafer aus Silizium. Ein Wafer ist mit der Schichtkombination aus Siliziumoxid-Siliziumnitrid-Siliziumoxid beschichtet und der zweite blanke Wafer wird mit dem ersten durch anodisches Bonden verbunden. Danach wird der zweite Wafer auf die für die Schicht 31 gewünschte Restdicke abpoliert. Die weiteren Prozeßschritte sind identisch mit den oben beschriebenen.

## Patentansprüche

1. Maske zur Strukturierung von Oberflächenbereichen mit Hilfe von Elektronenstrahlen, welche aus mindestens einer durchgehenden Schicht (30), einer das Maskenmuster definierenden Schicht (31) mit Fenstern, wobei die Schicht (31) auf der mindestens einen durchgehenden Schicht (30) angeordnet ist, und einem Halbleiterplättchen (32), auf dessen einer Oberfläche die Schichten (30, 31) aufgebracht sind, besteht, wobei eine wannenförmige Vertiefung (33) sich von der anderen Plattenoberfläche in das Halbleitermaterial (32) bis hin zur schichttragenden Oberfläche hineinerstreckt, dadurch gekennzeichnet daß
die durchgehende Schicht (30) eine Schichtkombination (30) aus Siliziumdioxid (34) / Siliziumnitrid (35) / Siliziumdioxid (36) ist, wobei die Schichtdicken der die Schicktkombination bildenden Schichten (34, 35, 36) so aufeinander abgestimmt sind, daß die Schichtkombination unter einer geringen Zugspannung steht.

2. Maske nach Anspruch 1 dadurch gekennzeichnet daß
die Zugspannung 10⁸ dynes/cm² beträgt.

3. Maske nach Anspruch 1 oder 2 dadurch gekennzeichnet daß
die Schichtkombination (30) eine Dicke von 0.1 µm bis 0.4 µm hat.

4. Maske nach einem der Ansprüche 1 bis 3 dadurch gekennzeichnet daß
die das Maskenmuster definierende Schicht (31) eine Dicke von 2.0 µm hat.

5. Maske nach einem der Ansprüche 1 bis 4 dadurch gekennzeichnet daß
die das Maskenmuster definierende Schicht (31) aus einkristallinem oder polykristallinem Silizium besteht.

## Claims

1. Mask for structuring regions of surface by means of electron beams, which mask comprises at least one continuous layer (30), a layer (31) containing windows which defines the mask pattern, with the latter layer (31) being positioned on at least one continuous layer (30), and a semiconductor wafer (32) to one of whose surfaces the layers (30, 31) are applied, with a trough-shaped depression (33) extending into the semiconductor material (32) from the other surface of the wafer to the surface carrying the layers, characterised in that the continuous layer (30) is a layer combination (30) composed of silica (34)/silicon nitride (35)/ silica (36), the thicknesses of the layers (34, 35, 36) forming the layer combination being so matched to one another that the layer combination is subject to low tensile stress.

2. Mask according to claim 1, characterised in that the tensile stress is 10⁸ dynes/cm².

3. Mask according to claim 1 or 2, characterised in that the thickness of the layer combination (30) is 0.1 µm to 0.4 µm.

4. Mask according to any of claims 1 to 3, characterised in that the thickness of the layer (31) defining the mask pattern is 2 µm.

5. Mask according to any of claims 1 to 4, characterised in that the layer (31) defining the mask pattern comprises monocrystalline or polycrystalline silicon.

## Revendications

1. Masque pour la structuration de zones de surface à l'aide de rayons d'électron, constitué d'au moins une couche continue (30), d'une couche (31) définissant le motif de masque, avec des fenêtres, la couche (31) étant disposée sur la au moins une couche continue (30), et une plaquette à semiconducteur (32), sur une surface de laquelle les couches (30, 31) sont appliquées, un creusement (33) en forme d'auge s'étendant depuis l'autre surface de plaque dans le matériau semiconducteur (32) jusqu'à la surface portant la couche, caractérisé en ce que
la couche continue (30) est une combinaison de couches (30), constituée de dioxyde de silicium (34) / nitrure de silicium (35) / dioxyde de silicium (36), les épaisseurs des couches (34, 35, 36) constituant la combinaison de couches étant adaptées les unes aux autres, de manière que la combinaison de couches soit exposée à une faible contrainte de traction.

2. Masque selon la revendication 1, caractérisé en ce que la contrainte de traction est de 10⁸ dynes/cm².

3. Masque selon la revendication 1 ou 2, caractérisé en ce que la combinaison de couches (30) a une épaisseur de 0,1 µm à 0,4 µm.

4. Masque selon l'une des revendications 1 à 3, caractérisé en ce que la couche (31) définissant le motif de masque a une épaisseur de 2,0 µm.

5. Masque selon l'une des revendications 1 à 4 caractérisé en ce que la couche (31) définissant le motif de masque est constituée de silicium monocristallin ou polycristallin.
